# EUROPÄISCHE PATENTANMELDUNG

(11) **EP 4 131 482 A1**
(43) Veröffentlichungstag der Anmeldung: **08.02.2023**
(21) Anmeldenummer: 21189912.5
(22) Anmeldetag: 05.08.2021
(51) Int. Cl.: H01M 4/139, G01N 21/01, H01M 10/04, G05B 19/18, G06N 20/00

(54) **HERSTELLUNGSVERFAHREN UND -ANLAGE FÜR BATTERIESPEICHER**

(71) Anmelder: Siemens Aktiengesellschaft, 80333 München (DE)
(72) Erfinder: Baldauf, Manfred, 91056 Erlangen (DE); Arzberger, Arno, 96135 Stegaurach (DE); Otte, Clemens, 81739 München (DE); Runkler, Thomas, 81929 München (DE); Steinbacher, Frank, 90542 Eckental (DE); Weber, Marc Christian, 80339 München (DE); Witt, Jonas, 96050 Bamberg (DE); Stoelben, Gunnar, 90763 Fürth (DE)

(57) **Zusammenfassung**

Verfahren zur Herstellung einer Elektrodenschicht eines Batteriespeichers sowie eine Herstellungsanlage zur Herstellung einer Elektrodenschicht eines Batteriespeichers welche einen schnellen und unmittelbaren Eingriff in den Herstellungsprozess ermöglichen und somit die Ausschussquote der Batterieherstellung reduzieren.

Das Verfahren bzw. die Herstellungsanlage erreicht dies durch folgende Schritte:
- Erfassen von mit der Herstellung der Elektrodenschicht assoziierten Anlagenparametern zumindest einer Anlage,
- Erfassen eines oder mehrerer Messwerte einer Messgröße der Elektrodenschicht-Paste und/oder der Elektrodenschicht,
- Berechnen/Ermitteln eines Korrekturwerts aus einem Vergleich des erfassten Messwerts der Elektrodenschicht mit einem festgelegten Sollwertbereich und
- Einstellen der Anlagenparameter in Abhängigkeit des berechneten Korrekturwertes.

## Beschreibung

### BESCHREIBUNGSEINLEITUNG

Die Erfindung betrifft ein Verfahren zur Herstellung einer Elektrodenschicht eines Batteriespeichers gemäß dem Oberbegriff des Patentanspruchs 1.

Des Weiteren betrifft die Erfindung eine Herstellungsanlage zur Herstellung einer Elektrodenschicht eines Batteriespeichers gemäß dem Oberbegriff des Patentanspruchs 11.

### STAND DER TECHNIK

Lithium-Ionen-Akkumulatoren, im Folgenden auch Lithium-Ionen-Batterien genannt, werden aufgrund ihrer hohen Leistungsdichte und Energiedichte in mobilen und stationären Anwendungen als Energiespeicher eingesetzt.

Eine Lithium-Ionen-Batterie umfasst typischerweise mehrere Batteriezellen. Eine Batteriezelle, insbesondere eine Lithium Ionen-Batteriezelle, umfasst eine Vielzahl von Schichten. Typischerweise umfassen diese Schichten Anoden, Kathoden, Separatoren und weitere Elemente. Diese Schichten können als Stapel oder als Wicklungen ausgestaltet sein.

Die Elektroden umfassen üblicherweise Metallfolien, insbesondere umfassend Kupfer und/oder Aluminium, welche mit einem Aktivmaterial beschichtet werden. Als Aktivmaterial wird dabei typischerweise eine Lithiumverbindungen- oder Kohlenstoffhaltige Paste, Slurry genannt, aufgetragen. Die Folien und die Beschichtung weisen jeweils eine Dicke von einigen Dutzend Mikrometern auf. Bereits einige Mikrometer Abweichung der Dicke der Beschichtung, der Porosität oder bei der Materialzusammensetzung begründen negative Auswirkungen auf die Qualität der Elektrode. Nachteilig werden bei unregelmäßiger Beschichtung somit qualitativ minderwertige Batteriezelle hergestellt. Weiterhin ist ein sicheres Betreiben der Batteriezelle nachteilig nicht sichergestellt.

Nach wie vor ist es eine Herausforderung, unterschiedliche Fehlerbilder (z.B. Kontaminationen, Luftblasenbildung) online im Beschichtungsprozess zu detektieren. Zum Teil werden sie erst nach Abschluss des gesamten Produktionsprozesses der Batteriezelle im Rahmen eines sogenannten End-of-Line-Tests offensichtlich. Teilweise werden fehlerhafte Beschichtungen auch erst nach mehreren Jahren der Batteriezelle im Betrieb festgestellt.

Nachteilig wird somit ein großer Anteil Ausschuss fehlerhafter Batteriezellen während der Batterieproduktion erzeugt. Somit weist der Produktionsprozess einen großen Materialbedarf und Energiebedarf auf, um eine ausreichende Menge qualitativ hochwertiger Batteriezellen zu produzieren.

Es ist somit Aufgabe der vorliegenden Erfindung, ein Verfahren zur Herstellung einer Elektrodenschicht eines Batteriespeichers sowie eine Herstellungsanlage zur Herstellung einer Elektrodenschicht eines Batteriespeichers bereitzustellen, welche einen schnellen und unmittelbaren Eingriff in den Herstellungsprozess ermöglichen und somit die Ausschussquote der Batterieherstellung reduzieren.

### LÖSUNG DER AUFGABE

Diese Aufgabe wird erfindungsgemäß mit einem Verfahren zur Herstellung einer Elektrodenschicht eines Batteriespeichers gemäß Anspruch 1 und eine Herstellungsanlage zur Herstellung einer Elektrodenschicht eines Batteriespeichers gemäß Anspruch 11 gelöst.

### BESCHREIBUNG DER ERFINDUNG

Das erfindungsgemäße Verfahren betrifft die Herstellung einer Elektrodenschicht eines Batteriespeichers in wenigstens einer Anlage unter Verwendung einer Elektrodenschicht-Paste. Das Verfahren umfasst mehrere Schritte. Zunächst erfolgt das Erfassen von mit der Herstellung der Elektrodenschicht assoziierten Anlagenparametern der Anlage. Ferner erfolgt das Erfassen eines oder mehrerer Messwerte wenigstens zweier Messgrößen der Elektrodenschicht-Paste und/oder der Elektrodenschicht. Weiterhin wird ein Korrekturwert aus einem Vergleich der erfassten Messwerte der Elektrodenschicht mit einem festgelegten Sollwertbereich für die Messgrößen ermittelt. In Abhängigkeit des ermittelten Korrekturwerts werden die Anlagenparameter eingestellt.

Die erfindungsgemäße Herstellungsanlage zur Herstellung einer Elektrodenschicht eines Batteriespeichers ist so ausgebildet, das erfindungsgemäße Verfahren durchzuführen.

Erfindungsgemäß wird unter einer Anlage insbesondere eine Einrichtung verstanden, in der einer oder mehrere der folgenden Prozessschritte erfolgen:
- Herstellung, Verarbeitung und/oder Förderung der Elektrodenschicht-Paste,
- Beschichtung der Elektrode mit der Elektrodenschicht-Paste,
- Trocknung der Beschichtung und/oder
- Kalandrierung der Elektrodenschicht.

Unter Elektrodenschicht-Paste (engl. Slurry) wird die Rohsubstanz für das Herstellen der Elektrodenschicht verstanden, die auf die Elektroden aufgetragen wird.

Als Anlagenparameter sind erfindungsgemäß ein oder mehrere Parameter zu verstehen, die in der Anlage einstellbar sind. Insbesondere sind auch beeinflussbare Umgebungseinflüsse unter Anlagenparametern zu verstehen. Zu Anlagenparametern zählen beispielsweise
- Massestrom der Elektrodenschicht-Paste,
- Rollengeschwindigkeit der Rollen beim Kalandrieren
- Eigenschaften der Düsen, insbesondere Ablagerungen und/oder Verstopfungen,
- Temperatur, insbesondere Schwankungen der Temperatur z.B. der Elektrodenschicht-Paste,
- Viskosität der Elektrodenschicht-Paste, und/oder
- Kontaminationen insbesondere der Elektrodenschicht-Paste etwa aus der Umgebung.

In Abhängigkeit von dem jeweiligen untersuchten Prozessschritt bezieht sich die Messgröße auf die Elektrodenschicht-Paste und/oder auf die aus der Elektrodenschicht-Paste erzeugte Elektrodenschicht. Messgrößen der Elektrodenschicht-Paste sind beispielsweise Temperatur, Viskosität, Partikelgrößenverteilung, Dispersionsgrad, Kontaminationen aus der Umgebung o.Ä.. Messgrößen der Elektrodenschicht sind etwa die Oberflächentopologie und -fehlstellen, Porosität, Zusammensetzung oder Bahnleitfähigkeit der Elektrodenschicht, bei der die Messwerte z.B. in Wirbelstrommessungen ermittelt werden.

Unter dem Korrekturwert ist/sind erfindungsgemäß ein oder mehrere Änderungen in den Anlagenparametern zu verstehen, um im weiteren Produktionsprozess eine gewünschte Änderung der Eigenschaften der Elektrodenschicht-Paste oder der Elektrodenschicht zu erlangen.

Die Ermittlung des Korrekturwerts erfolgt insbesondere durch einen Abgleich der Messwerte mit festgelegten Sollwert- und Fehlerwertbereichen, wobei im Falle von Messgrößen außerhalb des Sollwertbereichs für die Fehlerwertbereiche jeweils spezifische Korrekturwerte festgelegt sind.

Vorteile und Ausgestaltungen der Erfindung, die einzeln oder in Kombination miteinander einsetzbar sind, sind Gegenstand der Unteransprüche.

In einer vorteilhaften Ausführungsform der Erfindung umfasst die Elektrodenschicht-Paste ein Material, das Lithium enthält. Lithium, insbesondere die in Lithium-Ionen-Batterien verwendeten lithiumhaltigen Materialien umfassen eine besonders hohe Energiedichte.

Weiterhin ist es vorteilhaft, dass die Messwerte folgender Messgrößen gemessen werden:
- ein oder mehrere Oberflächenmerkmale, wie Auftreten von Agglomeraten, Vertiefungen und/oder Löchern, Kratzern, ausgefransten Rändern und/oder Rauhigkeiten,
- Schichtdicke, insbesondere zeitliche Schwankungen der Schichtdicke, und/oder räumliche Gradienten der Schichtdicke,
- Porosität der Schichtdicke, insbesondere räumliche und/oder zeitliche Schwankungen der Porosität und/oder
- eine oder mehrere räumliche Inhomogenitäten der elektrischen Leitfähigkeit, insbesondere räumliche und/oder zeitliche Schwankungen der Inhomogenität der elektrischen Leitfähigkeit.

In einer weiteren Ausführungsform des erfindungsgemäßen Verfahrens erfolgen zusätzlich folgende Schritte:
- Vergleichen der einen oder mehrerer Messwerte mit festgelegten Fehlerclustern,
- Wählen des Fehlerclusters und
- Einstellen der Anlagenparameter anhand eines für das Fehlercluster festgelegten Korrekturwertes.

Erfindungsgemäß wird unter einem Fehlercluster eine Zusammenfassung von Oberflächenphänomenen, d.h. Kombinationen von außerhalb des Sollwertbereichs liegender Messwerte eines oder mehrerer Messgrößen verstanden. Insbesondere kann die Kombination mehrerer auffälliger Messgrößen mit Messwerten außerhalb eines festgelegten Sollwertbereichs ein Fehlercluster sein, das für eine aktuelle Situation in der Anlage passt. Ein oder mehrere Anlagenparameter können anhand eines Korrekturwerts angepasst werden, wobei der Korrekturwert für das jeweilige Fehlercluster festgelegt ist. Der Korrekturwert kann mehrere einzelne Korrektureinzelwerte umfassen, die unterschiedliche Anlagenparameter betreffen. Insbesondere wird der Korrekturwert über Steuersignale an eine Anlagensteuerung zur Anpassung der Anlagenparameter übermittelt.

Eine weitere Ausführungsform des erfindungsgemäßen Verfahrens umfasst einen weiteren Verfahrensschritt, nämlich das Erstellen von Korrekturmodellen, die den Zusammenhang von Messwerten verschiedener Messgrößen, insbesondere bei Messwerten außerhalb eines Sollwertbereichs, mit Anlagenparametern abbilden. Korrekturmodelle können beispielsweise auf Basis von Laboruntersuchungen erstellt werden, bei denen der Zusammenhang von Messgrößen, insbesondere Oberflächenmerkmalen, bzw. von Fehlerclustern mit den verursachenden physikalischen Fehlerursachen abbilden. Diese Modelle können in sogenannten Softsensoren verwendet werden, um aus in der Produktionsanlage messbaren Größen die nötigen Korrekturwerte für die verursachenden Anlagenparameter zu ermitteln. In den Korrekturmodellen sind insbesondere diese Zusammenhänge und Korrekturwerte zum Wiedererlangen der Sollwerte in dem weiteren Verlauf des Herstellungsprozesses enthalten.

In einer weiteren Variante erstellt ein überwachtes oder nicht überwachtes maschinelles Lernverfahren in Kombination mit wissensbasierten Modellen und/oder physikalischen Modellen die Korrekturmodelle. Dadurch können in vorteilhafter Weise die aus Laboruntersuchungen und dem laufenden Betrieb der Anlage gewonnenen Erkenntnisse über die Zusammenhänge zwischen den Korrekturwerten und den Auswirkungen auf die Messgrößen analysiert und die Korrekturmodelle angepasst werden.

In einer vorteilhaften Ausführungsform nutzt das maschinelle Lernverfahren neuronale Netze, Deep-Learning Verfahren, Clustermethoden oder physikalisch informierte neuronale Netze, um die Korrekturmodelle anzupassen.

Die auf diese Weise oder wie vorangehend beschrieben mittels Laboruntersuchungen erstellten Korrekturmodelle können auch als sogenannte Soft-Sensoren in laufenden Produktionslinien der Anlage wie reale Sensoren eingesetzt werden, obwohl die zu ermittelnden Effekte nur indirekt aus anderen Messgrößen und Anlagenparametern abgeleitet werden.

In einer vorteilhaften Ausführungsform des Verfahrens erfolgt das Einstellen der Anlagenparameter mittels einer Feedbackschleife kontinuierlich während des Betriebs der Anlage.

In einer weiteren Ausführungsform erfolgt eine Anpassung der Korrekturmodelle in-situ und iterativ, indem die Auswirkungen der in der Feedbackschleife vorgenommenen Änderungen durch Umsetzung des Korrekturwerts analysiert werden und in einem maschinellen Lernverfahren in Kombination mit wissensbasierten Modellen für die Verbesserung der Korrekturmodelle bzw. Korrekturwerte benutzt werden.

In einer weiteren Ausführungsform der Erfindung übernimmt ein Soft-Sensor die Schritte Erfassen des einen oder mehrerer Messwerte einer Messgröße, das Ermitteln des Korrekturwerts sowie Einstellen der Anlagenparameter.

In einer weiteren Ausführungsform werden die Änderungen der Messwerte verschiedener Messgrößen im Nachgang einem Einstellen der Anlagenparameter anhand des Korrekturwertes verfolgt.

Die Erfindung umfasst ferner eine Herstellungsanlage zur Herstellung einer Elektrodenschicht eines Batteriespeichers, die so ausgeführt ist, dass sie dazu ausgebildet ist ein Verfahren nach den vorangehenden Ansprüchen durchzuführen.

### FIGURENBESCHREIBUNG

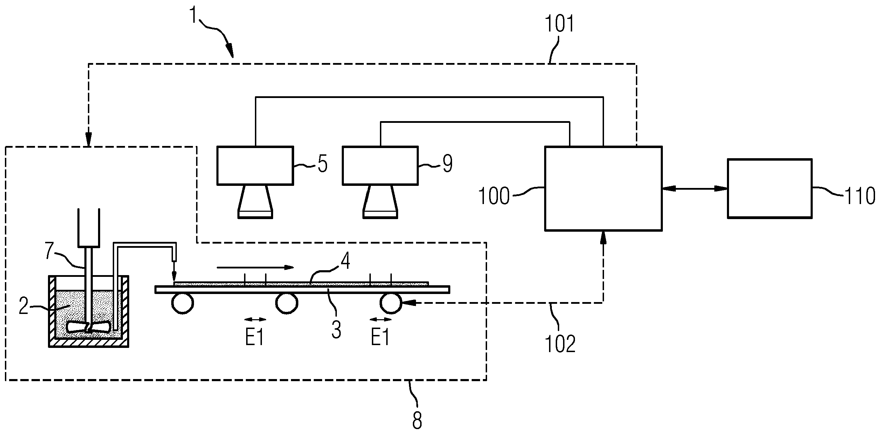

Im Folgenden wird die Erfindung anhand des in der Figur 1 dargestellten Ausführungsbeispiels näher beschrieben und erläutert.

Im Ausführungsbeispiel und der Figur können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

Figur 1 zeigt eine Herstellungsanlage 1. Die Herstellungsanlage 1 umfasst eine Elektrodenschichtherstellungseinrichtung 8. Die Elektrodenschichtherstellungseinrichtung 8 umfasst zwei Messeinrichtungen: Als eine erste Messeinrichtung 5 eine Laserscan-Einrichtung 5, als eine zweite Messeinrichtung eine Porositäts-Messeinrichtung 9. Beide Messeinrichtungen sind über Datenkabel mit einer Recheneinheit 100 verbunden.

Die Elektrodenschichtherstellungseinrichtung 8 umfasst ein Trägersubstrat 3, auf das eine Elektrodenschicht 4 aus einer Elektrodenschicht-Paste 2 (engl.: Slurry) aufgebracht wird. Die Elektrodenschicht-Paste 2 wird in einem Behälter mittels eines Rührwerks 7 homogenisiert. Das Rührwerk 7 und der Substrattransport sind ebenfalls über ein Datenkabel mit der Recheneinheit 100 verbunden.

Mit der Laserscan-Einrichtung 5 wird in diesem Beispiel als eine Messgröße wenigstens ein Bild der Elektrodenschicht 4 und eine Ortsinformation E1 aufgenommen. Weiterhin wird mittels der Porositäts-Messeinrichtung 9 eine zweite Messgröße, nämlich eine Porosität und/oder eine Elektrodenschichtdicke der Elektrodenschicht 4, bestimmt. In diesem Beispiel erfolgt die Analyse an derselben Stelle der Elektrodenschicht 4, nachdem das Substrat mit der Elektrodenschicht 4 weitertransportiert wurde, nun gekennzeichnet mit der Ortsinformation E1'. Die Analyse der Porosität erfolgt während der Herstellung der Elektrodenschicht 4. Die Porositäts-Messeinrichtung ist dann insbesondere als Ultraschall-Messeinheit, als Röntgenabsorptions-Einheit oder als Computertomograf ausgestaltet.

Die durch die Porositäts-Messeinrichtung 9 (erste Messgröße) und Laserscan-Einrichtung 5 (zweite Messgröße) ermittelten Messwerte werden in diesem Beispiel an die Recheneinheit 100 übertragen. In der Recheneinheit 100 werden dann die Messwerte, hier die topologischen Eigenschaften, der Elektrodenschicht 4 basierend auf wenigstens einem Bild der Laserscan-Einrichtung 5 in Abhängigkeit der Ortsinformation E1 bestimmt. In der Recheneinheit 100 erfolgt ein Abgleich der übertragenen Werte mit jeweils für die jeweiligen Messgrößen festgelegten Sollwertbereichen.

In einer Speichereinheit 110 sind Korrekturmodelle gespeichert, welche auf Basis von Laboruntersuchungen ermittelt wurden und den Zusammenhang von Oberflächenmerkmalen bzw. von Clustern von Merkmalen mit den insbesondere physikalischen Fehlerursachen abbilden. Ferner umfassen die Korrekturmodelle Korrekturwerte für Anlagenparameter der Herstellungsanlage, welche die Fehlerursachen im Betrieb der Anlage beheben können. Beispielhafte Korrekturwerte können die Viskosität oder die Temperatur der Elektrodenschicht-Paste, die Fördergeschwindigkeit der Elektrodenschicht-Paste, Partikelgrößenverteilung, Dispersion der Partikel im Slurry, die Rollengeschwindigkeit der Elektrodenfolien (Substarte), Zustand und Einstellung von Beschichtungsdüsen und -schlitzen, deren Spaltmaß etc. betreffen.

Die Recheneinheit 100 übermittelt die Korrekturwerte an die Steuerung der Elektrodenschichtherstellungseinrichtung 8, sodass eine Anpassung der Anlagenparameter im laufenden Betrieb der Herstellungsanlage 1 erfolgt.

Die auf diese Weise erstellten Korrekturmodelle werden auch Soft-Sensoren genannt, weil sie in der laufenden Produktionslinien wie reale Sensoren eingesetzt werden können, obwohl die zu ermittelnden Effekte nur indirekt aus anderen Mess-und Steuergrößen abgeleitet werden.

Die Höhe des Korrekturwerts kann entweder aus Messdaten angelernt sein oder in-situ durch die Auswirkung einer Feedbackschleife iterativ angepasst werden. Dabei eignet sich in vorteilhafter Weise der Einsatz einer KI Engine zum Anpassen, Verbessern und Trainieren der Korrekturmodelle. Die KI-Einheit ist mittels einer Datenleitung mit der Recheneinheit 100 verbunden. Dabei ist die KI-Einheit mit den von der Laserscan-Einrichtung 5 und der Porositäts-Messeinrichtung 9 übermittelten Daten sowie den mittels des Steuersignals 101 an die Elektrodenschichtherstellungseinrichtung 8 übermittelten ersten Steuersignale 101 und zweiten Steuersignale 102 verbunden. In anderen Ausführungsbeispielen könnte die KI-Einheit mit optischen Kameras in Kombination mit Bildverarbeitungsmethoden, Hyperspektralkameras und/oder Wirbelstrommesseinrichtungen verbunden.

Die KI-Einheit wertet somit die Wirkungen der Korrekturmodelle laufend aus und verbessert im laufenden Betrieb der Herstellungsanlage 1 die in der Speichereinheit 110 gespeicherten Korrekturmodelle.

### SCHLUSSBEMERKUNG

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

### Bezugszeichenliste

- 1: Anlage
- 2: Elektrodenschicht-Paste (Slurry)
- 3: Trägersubstrat
- 4: Elektrodenschicht
- 5: Laserscan-Einrichtung
- 7: Rührwerk
- 8: Elektrodenschichtherstellungseinrichtung
- 9: Porositäts-Messeinrichtung
- 100: Recheneinheit
- 101: erstes Steuersignal
- 102: zweites Steuersignal
- 110: Speichereinheit

## Patentansprüche

1. Verfahren zur Herstellung einer Elektrodenschicht eines Batteriespeichers mittels wenigstens einer Anlage, bei dem eine Elektrodenschicht-Paste verwendet wird, umfassend die folgenden Schritte:
- Erfassen von mit der Herstellung der Elektrodenschicht assoziierten Anlagenparametern zumindest einer Anlage,
- Erfassen eines oder mehrerer Messwerte einer Messgröße der Elektrodenschicht-Paste und/oder der Elektrodenschicht,
- Berechnen/Ermitteln eines Korrekturwerts aus einem Vergleich des erfassten Messwerts der Elektrodenschicht mit einem festgelegten Sollwertbereich und
- Einstellen der Anlagenparameter in Abhängigkeit des berechneten Korrekturwertes.

2. Verfahren nach Anspruch 1, **dadurch gekennzeichnet, dass** als Elektrodenschicht-Paste ein Material verwendet wird, das Lithium und/oder Kohlenstoff umfasst.

3. Verfahren nach einem der vorangehenden Ansprüche, **dadurch gekennzeichnet, dass** beim Erfassen des einen oder der mehreren Messwerte
- ein oder mehrere Oberflächenmerkmale,
- eine Schichtdicke,
- ein Gradient der Schichtdicke,
- eine Porosität der Schichtdicke und/oder
- eine oder mehrere räumliche Inhomogenitäten der elektrischen Leitfähigkeit
erfasst werden.

4. Verfahren nach einem der vorangehenden Ansprüche umfassend folgende Schritte:
- Vergleichen der einen oder mehreren Messwerte mit festgelegten Fehlerclustern,
- Wählen des vorliegenden Fehlerclusters und
- Einstellen der Anlagenparameter anhand eines für den Fehlercluster festgelegten Korrekturwertes.

5. Verfahren nach einem der vorangehenden Ansprüche umfassend folgenden Schritt:
- Erstellen von Korrekturmodellen, die den Zusammenhang von Messwerten verschiedener Messgrößen mit Anlagenparametern abbilden.

6. Verfahren nach einem der vorangehenden Ansprüche, wobei ein überwachtes oder nicht überwachtes maschinelles Lernverfahren in Kombination mit wissensbasierten Modellen und/oder physikalischen Modellen die Korrekturmodelle erstellt.

7. Verfahren nach einem der vorangehenden Ansprüche, wobei das maschinelle Lernverfahren neuronale Netze, Deep Learning Verfahren, Clustermethoden oder physikalisch informierte neuronale Netze verwendet.

8. Verfahren nach einem der vorangehenden Ansprüche, wobei das Einstellen der Anlagenparameter mittels einer Feedbackschleife erfolgt.

9. Verfahren nach einem der vorangehenden Ansprüche, wobei eine Anpassung der Korrekturmodelle in-situ durch die Auswirkung der Feedbackschleife auf die Messwerte iterativ erfolgt.

10. Verfahren nach einem der vorangehenden Ansprüche, wobei ein Soft-Sensor die Schritte Erfassen des einen oder mehreren Messwerte einer Messgröße, das Ermitteln des Korrekturwerts sowie Einstellen der Anlagenparameter ausführt.

11. Verfahren nach einem der vorangehenden Ansprüche umfassend folgenden Schritt:
- Erfassen der Änderungen der Messwerte verschiedener Messgrößen nach dem Einstellen der Anlagenparamater anhand des Korrekturwertes.

12. Herstellungsanlage zur Herstellung einer Elektrodenschicht eines Batteriespeichers, **dadurch gekennzeichnet, dass** sie dazu ausgebildet ist ein Verfahren nach den vorangehenden Ansprüchen durchzuführen.
